(19) Europäisches Patentamt
European Patent Office
Office européen des brevets

(11) **EP 2 811 525 B1**

(12) **EUROPEAN PATENT SPECIFICATION**

(45) Date of publication and mention
of the grant of the patent:
**13.02.2019 Bulletin 2019/07**

(21) Application number: **13401025.5**

(22) Date of filing: **14.03.2013**

(51) Int Cl.:
*H01L 29/417* *(2006.01)*  *H01L 29/45* *(2006.01)*
*H01L 29/786* *(2006.01)*  *H01L 27/12* *(2006.01)*
*H01L 29/66* *(2006.01)*  *H01L 29/423* *(2006.01)*
*H01L 29/49* *(2006.01)*  *H01L 29/06* *(2006.01)*
*B82Y 10/00* *(2011.01)*  *H01L 21/02* *(2006.01)*

(54) **Electrochemically-gated field-effect transistor, method for its manufacture, its use, and electronics comprising said field- effect transistor**

Elektro-chemisch kontrollierter Feldeffekttransistor, Methode zu dessen Herstellung, dessen Verwendung und diesen Feldeffekttransistor enthaltende Elektronik

Transistor à effet de champ commandé éledctro-chimiquement, procédé de son fabrication, son utilisation, et électronique comprenant un tel transistor à effet de champ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.12.2014 Bulletin 2014/50**

(73) Proprietor: **Karlsruher Institut für Technologie 76131 Karlsruhe (DE)**

(72) Inventors:
• **Dasgupta, Subho**
  **76344 Eggenstein-Leopoldshafen (DE)**
• **Hahn, Horst**
  **64342 Seeheim-Jugenheim (DE)**

(56) References cited:
**US-A1- 2005 133 788    US-A1- 2007 108 068**
**US-A1- 2007 131 975**

• **S. H. KIM; K. HONG; W. XIE; K. H. LEE; S. ZHANG; T. P. LODGE; C. D. FRISBIE: "Electrolyte-Gated Transistors for Organic and Printed Electronics", ADV. MATER. 25, 2012, XP002704027,**

EP 2 811 525 B1

## Description

The present invention relates to an electrochemically-gated field-effect transistor (FET), to a method for its manufacture, to its use, and to electronics comprising said field-effect transistor.

Printed or solution-processed electronics is a rapidly developing field for inexpensive and large-area electronics on flexible as well as rigid substrates. Printed logics encompass an important and large fraction of this activity. Worldwide there are huge and diverse efforts in search of appropriate organic or inorganic materials which are suitable for printed metallic, semiconducting, or dielectric layers in such electronic elements in order to improve the performance of devices, especially of field-effect transistors (FETs).

FETs are one of the most complex and hence widely studied electronic devices necessary to build logics. Solution-processed or printed components, which include metallic, semiconducting, and dielectric materials have been extensively studied and tested in order to optimize and improve the performance of this device. The semiconductor, which constitutes as channel material the active element of an FET, has been explored most extensively. Organic and low or high temperature processable inorganic semiconductors which are solution-processed or printed have been proposed and examined. Within this development, substantially good static electrical characteristics of FETs have already been achieved whereas the dynamic performance, i.e., the switching speed of the FETs, is still a major issue which is retarding their application in practice.

Since the field-effect mobility $\mu_{FET}$ is proportional to the switching frequency $f_T$, much effort has been made to improve the $\mu_{FET}$ of semiconductors in order to acquire a higher $f_T$. Although large improvements in the $\mu_{FET}$ of organic semiconductors have been achieved during the last decade, $\mu_{FET}$ hardly exceeds 1 cm$^2$/Vs, whereas inorganic semiconductors have shown slightly higher values. Nevertheless, these values are already comparable to amorphous silicon; however, the problem of the switching speed still persists in printed logics due to Equation (1):

$$f_T \infty \frac{\mu_{FET}}{L^2} \qquad (1)$$

According to Eq. (1), $f_T$ is inversely proportional to the square of the channel length $L$ of the FET. Within this respect it is important to acknowledge that the channel length $L$ of a printed device is usually rather large due to a limited printing resolution. A channel length $L$ between 20-30 $\mu$m is the minimum which can be achieved by using a modern-day printer. This value for the channel length $L$ is much larger compared to values known from silicon electronics where the channel length $L$ is lithographically determined to only a few tens of nanometres and thus drastically affects the switching speed of printed FETs.

Electrochemically-gated FETs in which inorganic oxides are employed as the transistor channel are described in WO 2012/ 025190 A1 as well as in refs. [1, 2].

In order to solve this issue with the limited resolution which a printer can offer, a new approach called *'self-aligned printing'* which is described in refs. [3-5] was introduced. Here, a first metallic electrode is placed onto a substrate and a selective modification of the surface of this electrode along with a change in surface energy is carried out by evaporating a self-assembled monolayer of an organic species onto it. When a second electrode is placed or printed on top of the first electrode, it dislikes the first electrode surface and flows off until it is completely separated aside from the first electrode. In this manner, a channel of a few hundreds of nanometers could be obtained. However, this process is slow and tedious, and the surface modification of one of the electrodes reduces the performance of the FET.

Electrochemical gating is known from ref. [6].

The main object of the present invention is therefore to provide an electrochemically-gated field-effect transistor (FET), a method for its manufacture, its use and printed electronics comprising said FET, which overcome the limitations known from the state of the art.

In particular, it is an object of the present invention to provide an electrochemically-gated FET where the channel length L is independent from the printing resolution and, as a result, much thinner and much shorter compared to the printing resolution.

In particular, it is a preferred object of the present invention to provide a method for manufacturing said FET through a completely solution-processed or printing route.

In particular, it is a preferred object of the present invention to provide flexible and/or bendable and/or transparent and/or printed electronics which applies said FET.

The solution of this problem is provided by an electrochemically-gated FET according to claim 1, by a method for its manufacture according to claim 6, by its use according to claim 14, and by electronics according to claim 15. The respective dependent claims describe preferred features.

The present invention according to claims 1 - 5 refers to an electrochemically-gated FET, which employs

- An arrangement which is placed on top of a substrate and which consists of

  - A first electrode, which is either a source electrode or a drain electrode,
  - A second electrode, which, in case the first electrode is the source electrode, it is the drain electrode, or, in case the first electrode is the drain electrode, it is the source electrode,
  - A transistor channel, which is located between the first electrode and the second electrode and does prevent any direct electrical contact between the first electrode and the second electrode;

- An electrolyte which is used as gate dielectric and which covers the transistor channel completely; and
- A gate electrode.

With respect to the present invention, the first electrode employs a first solid or porous metallic conducting body and is placed on top of the substrate.

According to the present invention, the transistor channel employs a porous semiconducting material and is placed on top of the first electrode by which it partially covers the first electrode, thereby leaving some uncovered area suitable for contacting the first electrode with electrical contacts available from outside the device. In a preferred embodiment, the transistor channel is partially placed on the substrate. In a particularly preferred embodiment, the transistor channel employs an organic or an inorganic or a carbon based nanomaterial, preferably organic or inorganic or carbon based nanoparticles, nanowires, nanorods, nanowhiskers, nanoflakes, nanofibres, or nanotubes, preferentially inorganic oxide nanoparticles.

The second electrode is placed partially on top of the transistor channel, which is itself arranged on top of the first electrode, which is itself positioned on top of the substrate. It is important that the second electrode at least partially covers the transistor channel but exhibits no direct physical contact to the first electrode in order to avoid any electric short circuit. In a preferred embodiment, the second electrode has a direct physical contact with the substrate.

The second electrode employs a second porous metallic conducting body. The second electrode is porous in order to allow an easy penetration of the electrolyte from above through its body down to the porous semiconducting transistor channel layer.

The electrolyte which acts as a dielectric penetrates through the transistor channel and may penetrate through the second electrode while leaving a part of the first electrode and a part of the second electrode uncovered. The latter feature is required in order to ensure that the electrical contact available from outside the device to the first electrode as well as to the second electrode is achieved without directly contacting the electrolyte. It is important to make sure that the complete transistor channel, which is sandwiched between the first electrode and the second electrode, must come into close, tight and inherent contact to the electrolyte. This is required for an accumulation of charge everywhere in the channel sandwiched between the source and the drain electrode and ensures that the transistor is in the situation to achieve an ON state. It is important to note that in case the electrolyte does not penetrate through the transistor channel all the way down to the first electrode, the device will not work properly since within the semiconducting transistor channel a layer will remain which does not show charge-carrier accumulation as long as no electrolyte has reached it.

Finally, the gate electrode comprises a third solid or porous metallic conducting body. It is placed in direct contact with the electrolyte but avoids any direct physical contact to any parts of the arrangement.

In a preferred embodiment, also called *top gate,* the gate electrode is placed on top of the arrangement, which consist of the first electrode, the second electrode, the transistor channel in between and the electrolyte covering or penetrating through any of these layers.

In an alternatively preferred embodiment, also called *side gate* or *displaced gate,* the gate electrode is placed on top of the substrate but aside from said arrangement.

An FET arranged according to the present invention defines the thickness of the porous semiconducting transistor channel as the channel length $L$, which is independent of the printing resolution and, in particular, can be much thinner and shorter than the printing resolution. Depending on the primary particle size of the nanomaterial in the transistor channel, the channel length $L$ is smaller than 1 $\mu$m, particularly smaller than 100 nm, preferentially smaller than 10 nm.

In addition, there is a further difference in the transistor geometry according to this invention compared to the usual geometry where both the source electrode and the drain electrode are placed on the same substrate. In the present geometry, not only the width $W$ of the channel but also the spread B of the channel is important. Depending on the thickness of the semiconductor layer which defines the channel length $L$ and the width $\times$ spread $W \cdot B$ of the transistor channel, which is defined as the common overlap area of the channel with both the source electrode and the drain electrode, a much larger current is able to pass through the transistor channel when the device is at the ON state. On the other hand, an initially low intrinsic carrier density in the semiconductor, which is defined by the carrier density at the unbiased state, i.e. at zero gate bias, would be essential to keep the OFF currents to a low value.

The present invention according to claims 6 - 13 further refers to a method of manufacturing an electrochemically-gated FET. According to the present invention, the following steps (a) to (e) are employed:

First, according to step (a), a first metallic conducting body, which is either solid or porous in nature, is placed on top of a substrate to be used as a first electrode.

Then, according to step (b), a porous semiconducting material which is provided to work as the active element of the FET, i.e. the transistor channel, is placed on top of the first electrode in a manner that it partially covers the first electrode and leaves some area uncovered for contacting the first electrode with outside contacts. In a specific embodiment, the second electrode is partially placed on the substrate. In particular, the porous semiconducting material is selected from an organic or an inorganic or a carbon based nanomaterial, preferably from organic or inorganic nanoparticles, nanowires, nanorods, nanowhiskers, nanoflakes, nanofibres, or nanotubes, preferentially from inorganic oxide nanoparticles.

Next, according to step (c), a second porous metallic conducting body is placed as second electrode on top of the transistor channel, which is placed on top of the first electrode. The placing is performed in a manner that the second electrode at least partially covers the transistor channel but does not directly contact the first electrode. In a specific embodiment, the transistor channel is partially placed on the substrate. By this step, an arrangement is obtained, which consists of the first electrode, of the second electrode, and of the transistor channel located between the first electrode and the second electrode.

Thereafter, according to step (d), an electrolyte which acts as a dielectric is applied on top of the arrangement in a manner that the electrolyte penetrates the transistor channel completely and may penetrate through the second electrode, while leaving a part of the first electrode and of the second electrode, respectively, uncovered.

In a preferred embodiment, the electrolyte is applied during step (d) in a manner that it penetrates at least through the transistor channel to reach up to the first electrode.

In an alternatively preferred embodiment, the electrolyte is applied during step (d) in a manner that it gets sucked into the transistor channel from all available sides. This embodiment is of particular importance when the second electrode is chosen from a solid body and does not possess any pores.

Finally, according to step (e), a third solid or porous metallic conducting body is placed to work as gate electrode in a manner that it is in direct physical contact with the electrolyte while no direct physical contact to the arrangement is obtained.

In a preferred embodiment, the gate electrode is placed during step (e) directly on top of the arrangement (top gate).

In another preferred embodiment, the gate electrode is placed during step (e) on top of the substrate but aside from the arrangement (side gate or displaced gate).

In a preferred embodiment, the placing of the first metallic conducting body and/or the placing of the second metallic conducting body and/or the placing of the third metallic conducting body and/or the placing of the porous semiconducting material and/or the applying of the electrolyte is performed by solution processing or by a printing technique which is based preferably on solution processing.

The present invention according to claim 15 further relates to printed electronics which comprises an electrochemically-gated field-effect transistor as described on any kind of flexible substrate, including paper or polymer. The obtained devices can be highly flexible or bendable since the metallic bodies, the semiconducting channels and the solid polymer-based electrolyte may be capable of enduring high strain.

The present invention shows a wide field of applications in high-performance transistors or logics or circuitry involving porous transistor channel and electrochemical-gating with solution-processable and/or printable solid polymer-based electrolytes. In addition, the present invention opens a way for use of FETs in applications involving partially or completely solution-processed and/or partially or completely printed electronic devices, transistors, logics, circuitry which involves such a device. Further, applications of the aforementioned device in the field of flexible and/or bendable and/or transparent and/or portable electronics and/or displays, smart packaging, smart toys, smart textiles, etc. are possible.

The main advantage of the FET geometry presented here is that all elements of the FET can be printed, whereby the channel length L is no longer limited by the printing resolution. Thus, the channel length L can be very small down to a few nanometres.

The present invention will be more apparent from the following description of non-limiting specific embodiments with reference to the drawings.

Fig. 1 shows a side/cross-sectional view of an FET where the gate is placed on top of the other layers (top gate).

Fig. 2 displays a top view of the FET of Fig. 1.

Fig. 3 exhibits a side/cross-sectional view of an FET where the gate is placed at the side of the other layers (side gate or displaced gate).

Fig. 4 displays a top view of the FET of Fig. 3.

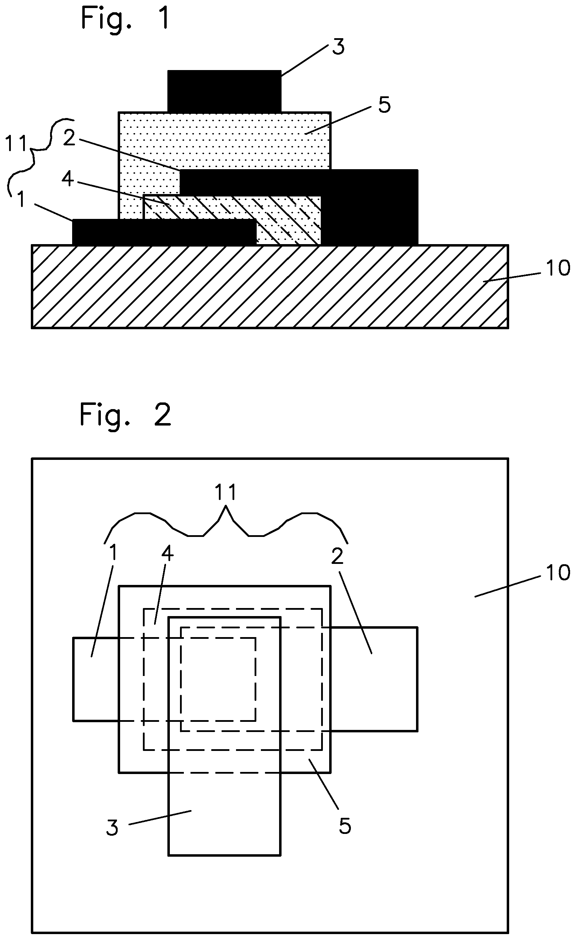

The manufacturing of an FET according to the present invention is fully compatible to an all-solution processed and all-printed synthesis. Referring to Figs. 1-4, the manufacturing of the device starts with a first metallic conducting body which is placed or positioned as first electrode 1, as an example also called source electrode, onto the substrate 10, preferably by a solution based technique, more preferably by a printing technique. The metallic conducting body is either solid and non-porous or porous in nature.

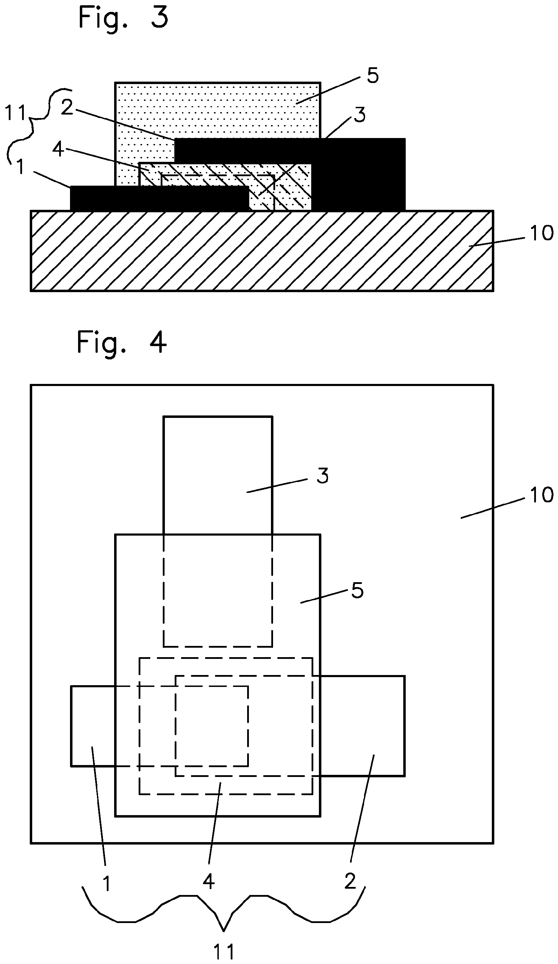

Next, the active element of the transistor, i.e., the semiconducting transistor channel 4 is placed or deposited on top of the first electrode 1 in a manner that it according to Figs. 1 and 3 partially covers the source electrode 1, thereby leaving some area uncovered for contacting the source electrode 1, and may partially be placed onto the substrate 10. The semiconducting material is preferentially placed by solution processing, more preferentially by printing techniques. The semiconducting channel layer must be porous in nature, preferentially provided by inorganic oxide nanoparticles.

Then, a second metallic conducting body is placed or positioned preferably by any solution based techniques, more preferably by printing techniques as second electrode **2**, as example also called *drain* electrode, on top of the first electrode **1** and on top of the semiconducting channel **4** in a manner that it at least partially covers the semiconducting channel **4** but has no direct physical contact to the first electrode **1**. In this example it shows direct physical contact with the substrate **10**. The second electrode **2** is porous in order to allow an easy penetration of the electrolyte **5** through the porous semiconducting transistor channel layer **4**, down to the first electrode **1**.

Next, an electrolyte **5** which acts a dielectric is applied on top of this three layer stack, i.e. an arrangement **11** of two body electrodes **1**, **2** and the transistor channel **4** sandwiched between them, in a manner that it either penetrates through the second electrode **2** and also penetrates the transistor channel **4** to reach up to the source electrode or gets sucked into the transistor channel **4** from all available sides in case the second electrode **2** is solid and non-porous. In both kinds of conditions, the complete semiconducting transistor channel layer **4** which is sandwiched between body electrodes **1** and **2** must come into contact to the electrolyte **5** for an accumulation of charge and to ensure that the transistor may achieve an ON state. The electrolyte **5** which is preferentially applied or placed or positioned or deposited by solution casting or more preferentially by printing must leave a part of the source and drain electrodes uncovered, as shown in **Figs. 1-4**, to allow electrical contacts to the body electrodes **1**, **2** without contacting the electrolyte **5**.

Finally, a third metallic conducting electrode which is solid and non-porous or porous in nature is placed or positioned as gate electrode **3** which keeps contact with the electrolyte **5** in a manner that it is, as shown in **Figs. 1-2**, either placed directly on top of the arrangement **11**, or placed, as shown in **Figs. 3-4,** at the side of the arrangement **11**. The gate electrode **5** is placed or positioned preferably by a solution-based technique, more preferably by a printing technique, in a manner that it exhibits only a contact to the electrolyte **5** and no electrical contact neither to the source electrode **1**, the drain electrode **2**, nor the semiconducting channel **4**, i.e. any part of the arrangement **11**.

**Literature**

[1] S. Dasgupta, G. Stoesser, N. Schweikert, R. Hahn, S. Dehm, R. Kruk, H. Hahn, Adv. Funct. Mater., 22 (2012) 4909-4919
[2] S. Dasgupta, R. Kruk, N. Mechau, H. Hahn, ACS Nano 5 (2011) 9628
[3] Y. -Y. Noh, N. Zhao, M. Caironi, H. Sirringhaus, Nature Nanotechnology 2 (2007) 784-789
[4] C. W. Sele, T. von Werne, R. H. Friend, H. Sirringhaus, Adv. Mater., 17 (2005) 997-1001
[5] L. Herlogsson, Y. -Y. Noh, N. Zhao, X. Crispin, H. Sirringhaus, M. Berggren, Adv. Mater. 20 (2008) 4708-4713
[6] S. H. Kim, K. Hong, W. Xie, K. H. Lee, S. Zhang, T. P. Lodge, C. D. Frisbie, Adv. Mater. 2012, DOI: 10.1002/adma.201202790

**Claims**

1. Electrochemically-gated field-effect transistor comprising an arrangement (11), an electrolyte (5) and a gate electrode (3), wherein the arrangement (11) is placed on top of a substrate (10) and consists of a first electrode (1), of a second electrode (2), and of a transistor channel (4), wherein the transistor channel (4), which comprises a porous semiconducting material, is located between the first electrode (1) and the second electrode (2) in a manner to prevent any direct electrical contact between the first electrode(1) and the second electrode (2), wherein the second electrode (2) comprises a second metallic conducting body, wherein the electrolyte (5) covers the transistor channel (4) completely and penetrates at least through the transistor channel (4) while leaving a part of the first electrode (1) and a part of the second electrode (2) uncovered, wherein the gate electrode (3), which comprises a third solid or porous metallic conducting body, is placed in direct contact with the electrolyte (5) but without any direct physical contact to the arrangement (11), wherein the first electrode (1), which comprises a first solid or porous metallic conducting body, is placed on top of the substrate (10),
**characterized in that**

   - the transistor channel (4) is placed on top of the first electrode (1), thereby partially covering the first electrode (1),
   - the second porous metallic conducting body comprised by the second electrode (2) is porous, wherein the second electrode (2) is placed on top of the transistor channel (4), which is placed on top of the first electrode (1), thereby at least partially covering the transistor channel (4), and
   - the length of the transistor channel (4) is smaller than 1 $\mu$m.

2. Electrochemically-gated field-effect transistor according to claim 1, **characterized in that** the gate electrode (3) is placed on top of the arrangement (11).

3. Electrochemically-gated field-effect transistor according to claim 1, **characterized in that** the gate electrode (3) is placed on top of the substrate (10) but aside from the arrangement (11).

4. Electrochemically-gated field-effect transistor according to one of the claims 1 to 3, **characterized**

**in that** the transistor channel (4) comprises a carbon based nanomaterial or an organic nanomaterial or an inorganic nanomaterial.

5. Electrochemically-gated field-effect transistor according to claim 4, **characterized in that** the transistor channel (4) comprises organic or inorganic or carbon based nanoparticles, nanowires, nanorods, nanowhiskers, nanoflakes, nanofibres, or nanotubes.

6. Method of manufacturing an electrochemically-gated field-effect transistor according to one of the claims 1 to 5, such method comprising **the following steps:**

    (a) Placing a first solid or porous metallic conducting body on top of a substrate (10) as a first electrode (1)
    (b) Placing a porous semiconducting material as a transistor channel (4) on top of the first electrode (1) in a manner that it partially covers the first electrode (1)
    (c) Placing a second porous metallic conducting body on top of the transistor channel (4) as a second electrode (2) in a manner that it at least partially covers the transistor channel (4) which is placed on top of the first electrode (1) but prevents any direct electrical contact to the first electrode (1), by which an arrangement (11), which consists of the first electrode (1), of the transistor channel (4), and of the second electrode (2), is obtained,
    (d) Applying an electrolyte (5) on top of the arrangement (11) in a manner that the electrolyte (5) penetrates at least through the transistor channel (4) completely down to the first electrode (1),
    (e) Placing a third solid or porous metallic conducting body as the gate electrode (3) in direct contact with the electrolyte (5) in a manner that no direct physical contact to the arrangement (11) is achieved.

7. Method according to claim 6, where during step (d) the electrolyte (5) is applied in a manner that it gets sucked into the transistor channel (4) from its sides.

8. Method according to claim 6, where during step (d) the electrolyte (5) is applied in a manner that it also penetrates at least partially through the second porous electrode (2).

9. Method according to one of the claims 6 to 8, where during step (e) the gate electrode (3) is placed directly on top of the arrangement (11) .

10. Method according to one of the claims 6 to 8, where during step (e) the gate electrode (3) is placed on top of the substrate (10) but aside from the arrangement (11).

11. Method according to one of the claims 6 to 10, where the placing of the first metallic conducting body and/or the placing of the second metallic conducting body and/or the placing of the third metallic conducting material and/or the placing of the porous semiconducting material and/or the applying of the electrolyte (5) is performed by a solution-processing method.

12. Method according to one of the claims 6 to 11, where the placing of the first metallic conducting body and/or the placing of the second metallic conducting body and/or the placing of the third metallic conducting material and/or the placing of the porous semiconducting material and/or the applying of the electrolyte (5) is performed by a printing method.

13. Method according to one of the claims 6 to 12, where the porous semiconducting material is selected from a carbon based nanomaterial or an organic nanomaterial or an inorganic nanomaterial.

14. Use of an electrochemically-gated field-effect transistor according to one of the claims 1 to 5 in flexible and/or bendable and/or transparent and/or printed electronics.

15. Electronics comprising an electrochemically-gated field-effect transistor according to one of the claims 1 to 5.

**Patentansprüche**

1. Elektrochemisch gesteuerter Feldeffekttransistor umfassend eine Anordnung (11), einen Elektrolyten (5) und eine Steuerelektrode (3), wobei die Anordnung (11) auf einem Substrat (10) angeordnet ist und aus einer ersten Elektrode (1), einer zweiten Elektrode (2) und einem Transistorkanal (4) besteht, wobei der Transistorkanal (4) der ein poröses halbleitendes Material umfasst, zwischen der ersten Elektrode (1) und der zweiten Elektrode (2) derart angeordnet ist, dass direkter elektrischer Kontakt zwischen der ersten Elektrode (1) und der zweiten Elektrode (2) verhindert wird, wobei die zweite Elektrode (2) einen zweiten metallischen leitfähigen Formkörper umfasst, wobei der Elektrolyt (5) den Transistorkanal (4) vollständig bedeckt und mindestens durch den Transistorkanal (4) dringt, und dabei einen Teil der ersten Elektrode (1) und einen Teil der zweiten Elektrode (2) unbedeckt lässt, wobei die Steuerelektrode (3), die einen dritten festen oder porösen metallischen leitfähigen Formkörper umfasst, in direktem Kontakt mit dem Elektrolyten (5) steht, aber ohne direkten physischen Kontakt mit der Anordnung (11), wobei die erste Elektrode (1), die einen ersten festen oder porösen metallisch leitfähigen Formkörper umfasst, auf dem Substrat (10) angeordnet ist, **dadurch gekennzeichnet, dass**

- der Transistorkanal (4) auf der ersten Elektrode (1) angeordnet ist, wobei er die erste Elektrode (1) teilweise bedeckt,
- der zweite poröse, metallische leitfähige Körper, den die zweite Elektrode (2)umfasst, porös ist, wobei die zweite Elektrode (2) auf dem Transistorkanal (4) angeordnet ist, welcher auf der erste Elektrode (1) angeordnet ist und dabei zumindest teilweise den Transistorkanal (4) bedeckt, und
- die Länge des Transistorkanals (4) kleiner als 1 $\mu$m ist.

2. Elektrochemisch gesteuerter Feldeffekttransistor nach Anspruch 1, **dadurch gekennzeichnet, dass** die Steuerelektrode (3) auf der Anordnung (11) angeordnet ist.

3. Elektrochemisch gesteuerter Feldeffekttransistor nach Anspruch 1, **dadurch gekennzeichnet, dass** die Steuerelektrode (3) auf dem Substrat (10) aber neben der Anordnung (11) angeordnet ist.

4. Elektrochemisch gesteuerter Feldeffekttransistor nach einem der Ansprüche 1 und 3, **dadurch gekennzeichnet, dass** der Transistorkanal (4) ein Kohlenstoff-basiertes Nanomaterial oder ein organisches Nanomaterial oder ein anorganisches Nanomaterial umfasst.

5. Elektrochemisch gesteuerter Feldeffekttransistor nach Anspruch 4, **dadurch gekennzeichnet, dass** der Transistorkanal (4) organische oder anorganische oder Kohlenstoff-basierte Nanopartikel, Nanodrähte, Nanostäbchen, Nanohärchen, Nanoflocken, Nanofasern oder Nanoröhrchen umfasst.

6. Verfahren zur Herstellung eines elektrochemisch gesteuerten Feldeffekttransistors nach einem der Ansprüche 1 bis 5, welches folgende Schritte umfasst:

(a) Aufbringen eines ersten festen oder porösen metallischen leitfähigen Formkörpers auf ein Substrat (10) als eine erste Elektrode (1)
(b) Aufbringen eines porösen, halbleitenden Materials als Transistorkanal (4) auf eine erste Elektrode (1) derart, dass er die erste Elektrode (1) teilweise bedeckt.
(c) Aufbringen eines zweiten porösen, metallischen leitfähigen Formkörpers auf einen Transistorkanal (4) als eine zweite Elektrode (2) derart, dass er zumindest teilweise den Transistorkanal (4) bedeckt, welcher auf der ersten Elektrode (1) angeordnet ist, aber direkten elektrischen Kontakt zu der ersten Elektrode (1) verhindert, wodurch eine Anordnung (11), die aus der ersten Elektrode (1), aus dem Transistorkanal (4) und der zweiten Elektrode (2) besteht, erhalten wird,
(d) Auftragen eines Elektrolyten (5) auf die Anordnung (11) derart, dass der Elektrolyt (5) zumindest den Transistorkanal (4) vollständig bis hinunter zur ersten Elektrode (1) durchdringt,
(e) Aufbringen eines dritten festen oder porösen, metallischen leitfähigen Körper als Steuerelektrode (3) in direktem Kontakt mit dem Elektrolyten (5) derart, dass kein direkter physischer Kontakt mit der Anordnung (11) besteht.

7. Verfahren nach Anspruch 6, wobei während Schritt (d) der Elektrolyt (5) derart aufgetragen wird, dass er vom Transistorkanal (4) durch dessen Seiten aufgesogen wird.

8. Verfahren nach Anspruch 6, wobei während Schritt (d) der Elektrolyt (5) derart aufgebracht wird, dass es zumindest teilweise in die zweite poröse Elektrode (2) dringt.

9. Verfahren nach einem der Ansprüche 6 bis 8, wobei während Schritt (e) die Steuerelektrode (3) direkt auf der Anordnung (11) aufgebracht wird.

10. Verfahren nach einem der Ansprüche 6 bis 8, wobei während Schritt (e) die Steuerelektrode (3) auf dem Substrat (10), aber neben der Anordnung (11) aufgebracht wird.

11. Verfahren nach einem der Ansprüche 6 bis 10, wobei das Aufbringen des ersten metallischen leitfähigen Formkörpers und/oder das Aufbringen des zweiten metallischen leitfähigen Formkörpers und/oder das Aufbringen des dritten metallischen leitfähigen Formkörpers und/oder das Aufbringen des porösen halbleitenden Materials und/oder das Auftragen des Elektrolyten (5) durch ein Lösungs-basiertes Verfahren durchgeführt wird.

12. Verfahren nach einem der Ansprüche 6 bis 11, wobei das Aufbringen des ersten metallischen leitfähigen Formkörpers und/oder das Aufbringen des zweiten metallischen leitfähigen Formkörpers und/oder das Aufbringen des dritten metallischen leitfähigen Formkörpers und/oder das Aufbringen des porösen halbleitenden Materials und/oder das Auftragen des Elektrolyten (5) durch ein Druckverfahren durchgeführt wird.

13. Verfahren nach einem der Ansprüche 6 bis 12, wobei das poröse, halbleitende Material aus einem Kohlenstoffbasierten Nanomaterial oder einem organischen Nanomaterial oder einem anorganischen Nanomaterial ausgewählt wird.

14. Verwendung eines elektrochemisch gesteuerten Feldeffekttransistors nach einem der Ansprüche 1 bis 5 in flexibler und/oder biegsamer und/oder transparenter und/oder gedruckter Elektronik.

15. Elektronik umfassend einen elektrochemisch gesteuerten Feldeffektentransistor nach einem der Ansprüche 1 bis 5.

**Revendications**

1. Transistor à effet de champ à déclenchement électrochimique comprenant un agencement (11), un électrolyte (5) et une électrode de grille (3), l'agencement (11) étant placé au dessus d'un substrat (10) et étant constitué par une première électrode (1), par une seconde électrode (2) et par un canal de transistor (4), le canal de transistor (4) qui renferme un matériau semi-conducteur poreux étant situé entre la première électrode (1) et la seconde électrode (2) de manière à empêcher tout contact électrique direct entre la première électrode (1) et la seconde électrode (2), la seconde électrode (2) comportant un second corps conducteur métallique, l'électrolyte (5) recouvrant totalement le canal de transistor (4) et pénétrant au moins au travers du canal de transistor (4) en laissant non recouvertes une partie de la première électrode (1) et une partie de la seconde électrode (2), l'électrode de grille (3) qui comporte un troisième corps conducteur métallique solide ou poreux étant en contact direct avec l'électrolyte (5) mais sans contact physique direct avec l'agencement (11), la première électrode (1) qui comprend un premier corps conducteur métallique, solide ou poreux étant située au-dessus du substrat (10),
**caractérisé en ce que**
le canal de transistor (4) est situé au-dessus de la première électrode (1) en recouvrant partiellement cette première électrode (1),

- le second corps conducteur métallique renfermé dans la seconde électrode (2) est poreux, la seconde électrode (2) étant située au-dessus du canal de transistor (4) qui est situé au-dessus de la première électrode (1), en recouvrant au moins partiellement le canal de transistor (4), et
- la longueur du canal de transistor (4) est inférieure à 1 $\mu$m.

2. Transistor à effet de champ à déclenchement électrochimique conforme à la revendication 1,
**caractérisé en ce que**

l'électrode de grille (3) est située au-dessus de l'agencement (11).

3. Transistor à effet de champ à déclenchement électrochimique conforme à la revendication 1,
**caractérisé en ce que**
l'électrode de grille (3) est située au-dessus du substrat (10) mais à côté de l'agencement (11).

4. Transistor à effet de champ à déclenchement électrochimique conforme à l'une des revendications 1 à 3,
**caractérisé en ce que**
le canal de transistor (4) renferme un nanomatériau à base de carbone ou un nanomatériau organique ou un nanomatériau inorganique.

5. Transistor à effet de champ à déclenchement électrochimique conforme à la revendication 4,
**caractérisé en ce que**
le canal de transistor (4) renferme des nanoparticules, des nanofils, des nanotiges, des nanofilaments, des nanoflocons, des nanofibres ou des nanotubes organiques ou inorganiques ou à base de carbone.

6. Procédé d'obtention d'un transistor à effet de champ à déclenchement électrochimique conforme à l'une quelconque des revendications 1 à 5, comprenant les étapes suivantes consistant à :

(a) positionner un premier corps conducteur métallique solide ou poreux au-dessus d'un substrat (10) en tant que première électrode (1),
(b) positionner un matériau semi-conducteur poreux constituant un canal de transistor (4) au-dessus de la première électrode (1) de sorte qu'il recouvre partiellement cette première électrode (1),
(c) positionner un second corps conducteur métallique poreux au-dessus du canal de transistor (4) en tant que seconde électrode (2) de sorte qu'il recouvre au moins partiellement le canal de transistor (4) qui est positionné au-dessus de la première électrode (1) mais empêche tout contact électrique direct avec la première électrode (1), un agencement (11) constitué par la première électrode (1) par le canal de transistor (4) et par la seconde électrode (2) étant ainsi obtenu,
(d) appliquer un électrolyte (5) au-dessus de l'agencement (11) de sorte que l'électrolyte (5) pénètre au moins au travers du canal de transistor (4) en descendant jusqu'à la première électrode (1),
(e) positionner un troisième corps conducteur métallique solide ou poreux en tant qu'électrode de grille (3) en contact direct avec l'électrolyte (5) de sorte qu'il n'y ait pas de contact physique direct avec l'agencement (11).

7. Procédé conforme à la revendication 6, selon lequel au cours de l'étape (d) l'électrolyte (5) est appliqué de sorte qu'il soit aspiré dans le canal de transistor (4) à partir de ses côtés.

8. Procédé conforme à la revendication 6, selon lequel au cours de l'étape (d) l'électrolyte (5) est appliqué de sorte qu'il pénètre également au moins partiellement au travers de la seconde électrode poreuse (2).

9. Procédé conforme à l'une des revendications 6, à 8, selon lequel au cours de l'étape (e) l'électrode de grille (3) est positionnée directement au-dessus de l'agencement (11).

10. Procédé conforme à l'une des revendications 6 à 8, selon lequel au cours de l'étape (e) l'électrode de grille (3) est positionnée au-dessus du substrat (10) mais à côté de l'agencement (11).

11. Procédé conforme à l'une des revendications 6 à 10, selon lequel le positionnement du premier corps conducteur métallique et/ou le positionnement du second corps conducteur métallique et/ou le positionnement du troisième corps conducteur métallique et/ou le positionnement du matériau semi-conducteur poreux et/ou l'application de l'électrolyte (5) est(sont) effectué(es) par un procédé de traitement en solution.

12. Procédé conforme à l'une des revendications 6 à 11, selon lequel le positionnement du premier corps conducteur métallique et/ou le positionnement du second corps conducteur métallique et/ou le positionnement du troisième corps conducteur métallique et/ou le positionnement du matériau semi-conducteur poreux et/ou l'application de l'électrolyte (5) est(sont) effectué(es) par un procédé d'impression.

13. Procédé conforme à l'une quelconque des revendications 6 à 12, selon lequel le matériau semi-conducteur poreux est choisi parmi un nanomatériau à base de carbone ou un nanomatériau organique ou un nanomatériau inorganique.

14. Utilisation d'un transistor à effet de champ à déclenchement électrochimique conforme à l'une des revendications 1 à 5, dans des systèmes électroniques flexibles et/ou repliables et/ou transparents et/ou imprimés.

15. Système électronique comprenant un transistor à effet de champ à déclenchement électrochimique conforme à l'une des revendications 1 à 5.

Fig. 1

Fig. 2

Fig. 3

Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012025190 A1

**Non-patent literature cited in the description**

- **S. DASGUPTA ; G. STOESSER ; N. SCHWEIKERT ; R. HAHN ; S. DEHM ; R. KRUK ; H. HAHN.** *Adv. Funct. Mater.,* 2012, vol. 22, 4909-4919
- **S. DASGUPTA ; R. KRUK ; N. MECHAU ; H. HAHN.** *ACS Nano,* 2011, vol. 5, 9628
- **Y. -Y. NOH ; N. ZHAO ; M. CAIRONI ; H. SIR-RINGHAUS.** *Nature Nanotechnology,* 2007, vol. 2, 784-789
- **C. W. SELE ; T. VON WERNE ; R. H. FRIEND ; H. SIRRINGHAUS.** *Adv. Mater.,* 2005, vol. 17, 997-1001
- **L. HERLOGSSON ; Y. -Y. NOH ; N. ZHAO ; X. CRISPIN ; H. SIRRINGHAUS ; M. BERGGREN.** *Adv. Mater.,* 2008, vol. 20, 4708-4713
- **S. H. KIM ; K. HONG ; W. XIE ; K. H. LEE ; S. ZHANG ; T. P. LODGE ; C. D. FRISBIE.** *Adv. Mater.,* 2012